# EUROPEAN PATENT APPLICATION

(11) **EP 2 560 204 A2**
(43) Date of publication of application: **20.02.2013**
(21) Application number: 12178974.7
(22) Date of filing: 02.08.2012
(51) Int. Cl.: H01L 25/07, H01L 23/48

(54) **Power semiconducter module and semiconducter module assembly with multiple power semiconducter modules**

(30) Priority: 17.08.2011 EP 11177800
(71) Applicant: ABB Technology AG, 8050 Zürich (CH)
(72) Inventor: Franc, Dugal, 8702 Zollikon (CH)
(74) Representative: ABB Patent Attorneys

(57) **Abstract**

The present invention provides a first presspin (6) with a foot (8), whereby a base (12) of the foot (8) is provided for contacting a contact element (4a, 4b) of a power semiconductor device (3), especially within a power semiconductor module (1) comprising a base plate (2) and at least one power semiconductor device (3), which is arranged on the base plate (2) and contacted by at least one further presspin (6, 7), whereby an insulation means (13) is provided for electrically isolating an outer surface (14) of the foot (8). The present invention further provides a power semiconductor module (1) comprising a base plate (2), at least one power semiconductor device (3), which is arranged on the base plate (2), and at least one first presspin (6), which is provided with an insulation means (13) as specified above for electrically isolating an outer surface (14) of the foot (8) of the first presspin (6), whereby the least one first presspin (6) is provided for contacting at least one contact element (4a, 4b) of the at least one power semiconductor device (3). The present invention also provides a power semiconductor module assembly, comprising multiple power semiconductor modules (1) as specified above, whereby the power semiconductor modules (1) are arranged side by side to each other with electric connections between adjacent power semiconductor modules (1).

## Description

### Technical Field

The present invention relates to a first presspin with a foot, whereby a base of the foot is provided for contacting a contact element of a power semiconductor device, especially within a power semiconductor module comprising a base plate and at least one power semiconductor device, which is arranged on the base plate and contacted by at least one second presspin. The present invention further relates to a power semiconductor module comprising a base plate, at least one power semiconductor device, which is arranged on the base plate, and at least one first presspin for contacting at least one contact element of the at least one power semiconductor device. The present invention also relates to a power semiconductor module assembly, comprising multiple power semiconductor modules.

### Background Art

First presspins of the afore-mentioned kind, which are for simplicity of the description also referred to as presspins, are well-known in the art and are used in the area of contacting power semiconductor devices, especially high power semiconductor devices. In this area, high currents of at least 30A for a normal operation mode and in case of failure in the range of 2000A pass through the presspin, preferably without affecting its integrity. Each presspin comprises a foot and a head, which are movable relative to each other along a longitudinal axis of the presspin and which are electrically interconnected, for example by a current bypass. Between the foot and the head a spring element is arranged, which exerts an outwardly directed force on the foot and the head for pushing them against contact elements of the power semiconductor devices and opposed contacts, e.g. a lid of a housing, to maintain electric connection there between. The spring element may be a spring washer pack, but other spring elements may be used as well. The contact between the foot and the respective contact element is provided via a base of the foot. Typically such presspins are used to contact gate or control contacts, collector contacts and / or emitter contacts.

Contact elements as mentioned above can be e.g. a top or bottom face of the power semiconductor device, depending on its arrangement, or a separate contact element provided on the base plate, particularly for contacting a control electrode of the power semiconductor device. The control electrode is typically a gate electrode, which is electrically connected by means of wire or the like to this separate contact element. The control electrode of the power semiconductor device is typically located on its top side.

For example only, the bottom or collector side of the semiconductor chip can be attached by soldering, sintering or the like to the base plate, which is electrically conductive, thereby forming a surface contact. The top or emitter side of the semiconductor device can be contacted by a presspin. The separate contact element connected to the gate electrode is arranged on and electrically isolated from the base plate, and also contacted by a presspin.

These power semiconductors devices may deal with voltages of about 1.7 kV or higher. The surface contact between the semiconductor device and the base plate additionally enables heat transfer away from the semiconductor, i.e. the semiconductor device is thermally and electrically coupled to the base plate. Typical power semiconductor devices used in this area are power transistors like insulated gate bipolar transistors (IGBT), reverse conducting insulated gate bipolar transistors (reverse conducting IGBT), bi-mode insulated gate transistors (BIGT) or (power) diodes.

Power semiconductor devices are frequently combined, e.g. for forming a power semiconductor module, which can deal with currents of up to 100 A or more. The power semiconductor devices are arranged in parallel on a base plate, which usually forms an electrically conducting base of the power semiconductor module. The power semiconductor module is usually covered by an electrically conducting lid, which provides a further contact for the power semiconductor devices. The power semiconductor devices are usually connected to the electrically conducting lid by means of the presspins. In case of power transistors, also the control contact is connected to the lid, whereby the lid is isolated from the control contact.

Multiple power semiconductor modules can further be combined to form a power semiconductor module assembly. The power semiconductor modules are arranged mechanically and electrically in parallel to each other in a common housing. The base plates of the semiconductor modules form an electrically conducting base of the module assembly. Additionally, the housing of the power semiconductor module assembly is also covered by an electrically conducting lid, which is in contact with the lids of the power semiconductor modules arranged therein. The power semiconductor module assembly can comprise identical power semiconductor modules, e.g. power semiconductor modules comprising power transistors, or different power semiconductor modules, e.g. a set of power semiconductor modules comprising power transistors and at least one power semiconductor module comprising diodes. Such power semiconductor module assemblies are e.g. known as "Stakpak" from the applicant and can be used for forming stacked arrangements as used for example in HVDC applications, which deal with up to several hundred kV. Accordingly, the mechanical design of the power semiconductor module assembly is optimized in order to facilitate clamping in long stacks. In these stacked arrangements, mechanical and electrical stability of a single power semiconductor module assembly is essential to prevent failures of the entire stacked arrangement.

Instead of arranging the power semiconductor modules into power semiconductor module assemblies and stacking of the power semiconductor module assemblies, the power semiconductor modules can also be stacked directly.

In this context, support of a short circuit failure mode (SCFM) of the individual power semiconductor devices is an essential feature. In case one of the power semiconductor devices fails, it fails by providing a short circuit to enable conduction from the base plate to the lid. This refers to the power semiconductor modules as well as to the power semiconductor module assemblies, which are disabled in SCFM. When multiple of the power semiconductor modules or the power semiconductor module assemblies are connected in series, e.g. forming the above-mentioned stacked arrangement, failure of a single power semiconductor device does not lead to a failure of the series of the power semiconductor modules or the power semiconductor module assemblies.

Especially in this short circuit failure mode, very high currents of up to 2000A can flow through a single power semiconductor device and the respective presspin in contact with the failing power semiconductor device, since the short circuit bridges all parallel power semiconductor devices. To achieve a high life time of these power semiconductor devices and accordingly a high life time of the power semiconductor modules and the power semiconductor module assemblies, it is desired that the short circuit failure mode can be maintained for a year or even more.

Due to the high currents in SCFM, the quality of the electric connection between the contact element and the foot of the presspin can reduce over the time. Arcing between the presspin in contact with the power semiconductor device in SCFM and other presspins can occur. Accordingly, the contact element and the foot of the presspin underlie wearing and oxidation, thereby increasing the resistance of the electric connection there between, which reduces the short circuit capabilities in SCFM. Electrical arcing can even lead to consumption of the entire presspin in contact with the power semiconductor device in SCFM. The arcing can also propagate to other presspins, until all of them are entirely consumed, or in other words destroyed. This would result in a failure of the power semiconductor module and accordingly of the power semiconductor module assembly comprising the power semiconductor device in SCFM. When a presspin is consumed, its spring washer pack is not able to maintain electric contact between the contact element and the lid as required for operation of the power semiconductor module.

The problem of arcing and pin consumption also refers to presspins, which are not carrying the load current, and which were therefore thought to be suitable to maintain the mechanical stability of the power semiconductor modules and the power semiconductor module assemblies. This particularly refers to gate contacts of the power semiconductor devices, which do not carry the load current during SCFM and therefore are used in a power semiconductor module to maintain its mechanical stability. Accordingly, presspins contacting the gate should never been consumed. Therefore, it is very important to prevent electrical arcing at these presspins, especially in short circuit failure mode.

In the art, the problem of propagation of electrical arcing is intended to be solved by a proper design of power semiconductor modules. Nevertheless, it has turned out that even when placing individual presspins at large distances apart from each other, electrical arcing and consumption of the presspins cannot reliably be prevented. Even presspins contacting the control contact can still be affected by the electrical arcing.

### Disclosure of Invention

It is an object of the present invention to provide a power semiconductor module comprising a first presspin that provides a good electrical and mechanical stability and has a long life-time, even in the presence of electrical arcing. It is a further object of the present invention to provide a power semiconductor module arrangement, which has an increased life-time, especially when operating in short circuit failure mode.

This object is achieved by the independent claims. Advantageous embodiments are given in the dependent claims.

In particular, the invention provides a power semiconductor module comprising a first presspin with a foot, whereby a base of the foot is provided for contacting a contact element of a power semiconductor device, especially within a power semiconductor module comprising a base plate and at least one power semiconductor device, which is arranged on the base plate, whereby an insulation means is provided for electrically isolating an outer surface of the foot. The power semiconductor device may be contacted by at least one further presspin.

. The present invention also provides a power semiconductor module assembly, comprising multiple power semiconductor modules as specified above, whereby the power semiconductor modules are arranged side by side to each other with electric connections between adjacent power semiconductor modules.

The basic idea of the invention is to electrically isolate and protect the outer surface of the foot of the presspin with an isolation means. On the one hand side, the insulation means prevent the appearance of electrical arcing at a first presspin, which may carry a high load current, e.g. in short circuit failure mode (SCFM). On the other hand, the insulation means prevents first presspins, which are not carrying a high load current, from being consumed due to electrical arcing originated at a further presspin. The further presspin can be another first presspin or a second presspin, which is a conventional presspin known in the art. The isolating means require good electrical isolation capabilities, so that they can effectively reduce the appearance of electrical arcing and the consumption of first presspins due to electrical arcing. Since electrical arcing can never completely be eliminated, it is also required that the insulation means has a high melting temperature, so that it maintains the insulation capabilities for a long time. Since the temperature around electrical arcing can reach a few hundred degrees Celsius, the melting temperature of the insulating means is preferably higher than the temperature caused by electrical arcing. A power semiconductor module having at least one first presspin will have an increased life-time, since the insulation means reduces the consumption of the first presspin and the power semiconductor module can be operated for a prolonged period of time in short circuit failure mode. Also, the mechanical stability of the power semiconductor module will be maintained for a prolonged period of time, since the consumption of the first presspin is reduced. By reducing arcing at the first presspin carrying a high load current, e.g. in SCFM, also the lifetime of other first and second presspins in the power semiconductor module is increased. Accordingly, the power semiconductor module as well as the power semiconductor module assembly can be operated for a prolonged time before failure occurs and replacement is required. This also increases the lifetime and reduces maintenance intervals of stacked arrangements of power semiconductor modules as well as the power semiconductor module assemblies.

According to a preferred embodiment of the invention, the insulation means is provided having a tubular body, which is arranged to surround the foot. The cross shape of the tubular body is preferably adapted to the cross shape of the foot. A circular cross shape is preferred. The tubular body can easily be mounted to the foot of the first presspin providing insulation over its entire circumference.

According to a preferred embodiment of the present invention, the tubular body has a thickness of 0.5 mm to 2.0 mm. This thickness is most suitable for today's common first presspins. Depending on the particular design of the first presspin and the involved currents, the thickness may also be bigger or smaller.

According to a preferred embodiment of the present invention, the insulation means extends over the entire height of the foot. In this manner, the entire foot is insulated and electrical arcing is best prevented.

According to a preferred embodiment of the invention, the insulating means comprises a ceramic base material. Preferably, the insulation means is entirely made of the ceramic base material. The ceramic base material provides good insulation capabilities and has a high melting temperature.

In a preferred embodiment of the invention, the ceramic base material is Al₂O₃, which is also known as alumina. Alumina is a well-known ceramic material, which is preferred due to its good insulation capabilities and its high melting temperature.

In a preferred embodiment of the power semiconductor module of the invention, at least one second presspin is provided for contacting at least one contact element of the one or multiple power semiconductor devices. Accordingly, first and second presspins can be combined in the power semiconductor module to keep it simple and cheap. To maintain mechanical stability of the power semiconductor module, it is only required to protect some of the presspins, i.e. the first presspins.

According to a modified embodiment of the power semiconductor module of the invention, at least one power semiconductor devices is an insulated gate bipolar transistor, a reverse conducting insulated gate bipolar transistor, a bi-mode insulated gate transistor, or a diode. These power semiconductor devices are suitable for being operated in high power conditions and can deal with high voltages and currents. Preferably, multiple identical power semiconductor devices are combined in a single power semiconductor module. Alternatively, an arbitrary set of power semiconductor devices from the listed power semiconductor devices is combined in a single power semiconductor module.

According to a modified embodiment of the power semiconductor module of the invention, the power semiconductor module comprises multiple power semiconductor devices with at least one contact element provided as a common control contact of the multiple power semiconductor devices, and a first presspin is in contact with the least one contact element provided as the common control contact. Control contacts only have to deal with relatively small currents, so that they can easily be combined. This allows providing a contact element with a surface sufficiently big for being contacted by standard first or second presspins without occupying too much space on the base plate. This allows an efficient design of the power semiconductor module. Also, first or second presspins with unique dimensions can be used for contacting all contact elements of the power semiconductor devices. The common control contact is placed on the base plate, but not in electrical contact with the base plate. Preferably, an insulating layer is provided between the common control contact and the base plate.

According to a modified embodiment of the power semiconductor module of the invention, the power semiconductor module comprises a housing, whereby an electrically conducting lid forms a top side of the housing and provides a first contact of the power semiconductor module, the base plate forms a base of the housing and provides a second contact of the power semiconductor module, a first contact of the at least one power semiconductor device is in electric contact with the lid via a first or second presspin and a control contact of the at least one power semiconductor device is in contact with the lid via a first presspin. Preferably, first or second presspins are provided between the semiconductor devices and the lid for providing the electrical contact. Generally speaking, the lid provides a common first contact of the power semiconductor module for contacting the first contacts of the power semiconductor devices, and the base plate provides a second contact of the power semiconductor module. The first and second contact of the power semiconductor module can be contacted by other power semiconductor modules in the case of a stacked arrangement or by respective contacts of a power semiconductor module assembly. In the case of power transistors like IGBTs, the first contact refers to an emitter contact, the second contact refers the collector contact, and the control contact refers to a gate contact. The control contact is not in electric contact with the lid of the power semiconductor module and can be contacted e.g. through a gap in the lid or by a lateral contact of the power semiconductor module.

According to a preferred embodiment of the power semiconductor module assembly of the invention, the base plates of the power semiconductor modules are electrically connected to each other. The connection can be made by wiring or by providing a contact plate for contacting the base plates and/or the lids of the semiconductor modules. The first contacts and/or the second contacts of the power semiconductor modules accordingly form a common first and/or second contact of the power semiconductor module assembly. In case of the power semiconductor modules containing at least one power transistor, the control contact can be electrically connected.

According to a preferred embodiment of the power semiconductor module assembly of the invention, the power semiconductor module assembly comprises a housing, whereby an electrically conducting lid forms a top side of the housing and provides a first contact of the power semiconductor module assembly, which is in contact with the first contacts of the power semiconductor modules, and the base plates of the power semiconductor modules extend through a base of the housing. The first and second contacts of the power semiconductor module assembly can be contacted by other power semiconductor module assemblies in the case of a stacked arrangement. Generally speaking, the lid of the power semiconductor module assembly provides a first contact for contacting the first contacts of the power semiconductor modules and the base plates of the power semiconductor modules provide a common second contact of the power semiconductor modules. In case the power semiconductor modules have control contacts, they can also be electrically connected within the power semiconductor module assembly. The power semiconductor module assembly can have a lateral contact for contacting the connected control contacts of the power semiconductor modules, or the connected control contacts of the power semiconductor modules can be contacted through a gap in the lid. The first and second contact of the power semiconductor module assembly can be contacted by other power semiconductor module assemblies in the case of a stacked arrangement. In the case of power transistors like IGBTs, the first contact refers to an emitter contact, the second contact refers to a collector contact, and the control contact refers to a gate contact.

### Brief Description of Drawings

These and other aspects of the invention will be apparent from and elucidated with reference to the embodiments described hereinafter.

In the drawings:

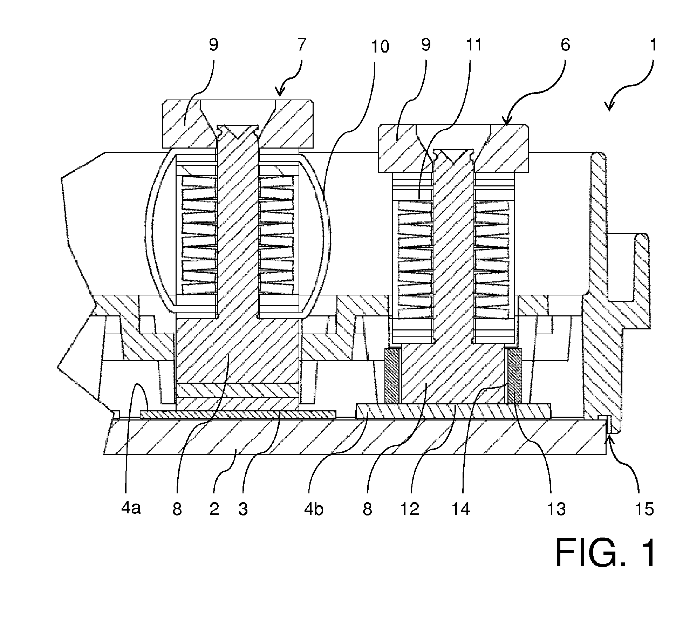

- Fig. 1: shows a partial sectional view of a power semiconductor module with a power semiconductor device and a first and a second presspin contacting contact elements of the power semiconductor device.

### Detailed Description of the Invention

Fig. 1 shows a part of a power semiconductor module 1 according to the present invention. The power semiconductor module 1 comprises an electrically conducting base plate 2 and a power semiconductor device 3, which is arranged on the base plate 2. The top side 4a of the semiconductor device 3 forms a first contact thereof, which is a first contact element according to the invention. A second contact of the power semiconductor device 3 is formed at its bottom side, which is in electric contact with the base plate 2. A control contact of the power semiconductor device 3 is connected to a separate contact element 4b, which is another contact element for the power semiconductor device 3 according to the invention. The separate contact element 4b is also referred to as control contact. The separate contact element 4b is provided with a planar shape on the base plate 2, but electrically insulated from the base plate 2 by an insulating layer, which is not visible in the figure.

The power semiconductor device 3 in this embodiment of the present invention is an insulated gate bipolar transistor (IGBT), the first contact is an emitter contact, the second contact is a collector contact and the control contact is a gate contact. Accordingly, the separate contact element 4b is connected to the gate contact is also referred to as gate runner.

The gate runner 4b is contacted by a gate pin 6, which is a first presspin according to the present invention. The top side 4a of the power semiconductor device 3 is contacted by a chip pin 7, which is a second presspin according to the present invention. The gate pin 6 as well as the chip pin 7 comprise each a foot 8 and a head 9, which are in electrical contact, for example by a current bypass 10, and a spring washer pack 11 exerting an outwardly directed force on the foot 8 and the head 9. Instead of the spring washer pack also another spring element may be used.

Now referring to the first press pin 6, i.e. the gate pin 6, its foot 8 has an end face as base 12, which is in electric contact with the gate runner 4b. According to the invention, an insulation means 13 is provided around the outer surface 14 of the foot 8 for providing an electric isolation. The insulation means 13 has a tubular body, which is arranged to surround the foot 8. The tubular body of the insulating means 13 extends over the entire height of the foot 8. In this embodiment of the present invention, the tubular body has a thickness of approx. 1.0 mm, although in different embodiments of the invention, the thickness can vary preferably between 0.5 mm and 2.0 mm. The insulation means 13 are made of a ceramic base material, which in this embodiment of the present invention is alumina, also known as Al₂O₃.

Although not explicitly shown in Fig. 1, the power semiconductor module 1 comprises multiple of the afore-described power semiconductor devices 3. The top side 4a of each power semiconductor device 3 is contacted by a respective chip pin 7. The control electrodes of the power semiconductor devices 3 are connected to one or more than one common contact element, i.e. the gate runner 4b as described above, which is contacted by the gate pin 6 as described above. In case more than one common contact element is used, each contact element is contacted by a respective gate pin 6. Accordingly, the power semiconductor module 1 is formed with multiple power semiconductor devices 3 arranged in parallel to each other. In case of diodes are used in addition to controllable power semiconductor devices 3, they are arranged anti-parallel.

The power semiconductor module 1 comprises a housing 15, whereby the base plate 2 forms a base of the housing 15. An electrically conducting lid, which is not explicitly shown in the figure, forms a top side of the housing 15. The lid provides a first contact of the power semiconductor module 1 and the base plate 2 provides a second contact of the power semiconductor module 1. The power semiconductor devices 3 are in electric contact with the lid by means of first and second presspins 6, 7, which are provided between the contact elements 4a, 4b of the power semiconductor devices 3 and the lid. The base plate 2 is connected to the collectors of the power semiconductor devices 3 and forms a second contact of the power semiconductor module 1, and the emitters of the power semiconductor devices 3 are connected to the lid. The gates of the power semiconductor devices 3 can be commonly contacted in the power semiconductor module 1 through a gap in the lid.

A power semiconductor module assembly, which is not explicitly shown in the figure, comprises multiple power semiconductor modules as described above. The power semiconductor modules 1 are arranged side by side to each other within a housing, whereby the base plates 2 of the power semiconductor modules 1 extend through a base of the housing. An electrically conducting lid forms a top side of the housing and provides a common contact for the power semiconductor modules 1 with electric connections between adjacent power semiconductor modules 1. The lid provides a first contact of the power semiconductor module assembly for contacting the first contacts of the power semiconductor modules 1 and the base plates 2 commonly provide a second contact of the power semiconductor module assembly. The control contacts of the power semiconductor modules 1 are connected to each other within the power semiconductor module assembly and to a lateral electric contact of the power semiconductor module assembly.

The power semiconductor module assembly comprises different semiconductor modules, in this exemplary embodiment of the invention a set of power semiconductor modules 1 comprising power transistors and at least one power semiconductor module comprising diodes.

The power semiconductor modules 1 as well as the power semiconductor module assemblies can be stacked.

While the invention has been illustrated and described in detail in the drawings and foregoing description, such illustration and description are to be considered illustrative or exemplary and not restrictive; the invention is not limited to the disclosed embodiments. Other variations to be disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or " an" does not exclude a plurality. The mere fact that certain measures are recited in mutually different dependent claims does not indicate that a combination of these measures cannot be used to advantage. Any reference signs in the claims should not be construed as limiting scope.

### Reference signs list

- 1: power semiconductor module
- 2: base plate
- 3: power semiconductor device
- 4a: contact element, top side of power semiconductor device
- 4b: contact element, gate runner, common control contact
- 6: first presspin, gate pin
- 7: second presspin, chip pin
- 8: foot
- 9: head
- 10: current bypass
- 11: spring washer pack
- 12: base, end face
- 13: insulation means
- 14: outer surface
- 15: housing

## Claims

1. Power semiconductor module (1) comprising
a base plate (2),
at least one power semiconductor device (3), which is arranged on the base plate (2), and
at least one first presspin (6) comprising a foot and a head, the foot and the head are movable relative to each other along a longitudinal axis of the presspin, the foot and the head are electrically interconnected and a spring element is arranged between the foot and the head exerting an outwardly directed force on the foot and the head,whereby the least one first presspin (6) is provided for contacting at least one contact element (4a, 4b) with a base (12) of the foot (8) wherein
the at least one first presspin (6) is provided with an insulation means (13) having a tubular body for electrically isolating an outer surface (14) of the foot (8) of the first presspin (6).

2. The power semiconductor module according to preceding claim 1,
wherein
the insulation means (13) is arranged to surround the foot (8).

3. The power semiconductor module according to any of the preceding claims,
wherein
the tubular body has a thickness of 0.5 mm to 2.0 mm.

4. The power semiconductor module according to any of the preceding claims,
wherein
the insulation means (13) extends over the entire height of the foot (8).

5. The power semiconductor module according to any of the preceding claims,
wherein
the insulation means (13) comprises a ceramic base material.

6. The power semiconductor module according to preceding claim 5,
**characterized in that**
the ceramic base material is Al₂O₃.

7. Power semiconductor module (1) according to any of the preceding claims,
wherein
at least one second presspin (7) is provided for contacting at least one contact element (4a, 4b) of the one or multiple power semiconductor devices (3), wherein the second presspin (7) comprises a foot and a head, the foot and the head are movable relative to each other along a longitudinal axis of the presspin, the foot and the head are electrically interconnected and a spring element is arranged between the foot and the head exerting an outwardly directed force on the foot and the head.

8. Power semiconductor module (1) according to any of the preceding claims,
wherein
the at least one power semiconductor device (3) is an insulated gate bipolar transistor, a reverse conducting insulated gate bipolar transistor, a bi-mode insulated gate transistor, or a diode.

9. Power semiconductor module (1) according to any of the preceding claims,
wherein
the power semiconductor module (1) comprises multiple power semiconductor devices (3) with at least one contact element provided as a common control contact (4b) of the multiple power semiconductor devices (3), and
the at least one first presspin (6) is in contact with the least one contact element provided as the common control contact (4b).

10. Power semiconductor module (1) according to claim 9,
wherein
the common control contact (4b) is provided on the base plate (2).

11. Power semiconductor module (1) according to any of the preceding claims,
wherein
the power semiconductor module (1) comprises a housing (15), whereby an electrically conducting lid forms a top side of the housing (15) and provides a first contact of the power semiconductor module (1),
the base plate (2) forms a base of the housing (15) and provides a second contact of the power semiconductor module (1),
a first contact of the at least one power semiconductor device (3) is in electric contact with the lid via a first or second presspin (6, 7), and
a control contact (4b) of the at least one power semiconductor device (3) is in contact with the lid via a first presspin (6).

12. Power semiconductor module assembly, comprising multiple power semiconductor modules (1) according to any of preceding claims 1 to 11,
whereby
the power semiconductor modules (1) are arranged side by side to each other with electric connections between adjacent power semiconductor modules (1).

13. Power semiconductor module assembly according to preceding claim 12,
**characterized in that**
the base plates (2) of the power semiconductor modules (1) are electrically connected to each other.

14. Power semiconductor module assembly according to any of preceding claims 12 or 13,
**characterized in that**
the power semiconductor module assembly comprises a housing, whereby an electrically conducting lid forms a top side of the housing and provides a first contact of the power semiconductor module assembly, which is in contact with the first contacts of the power semiconductor modules (1), and
the base plates (2) of the power semiconductor modules (1) extend through a base of the housing.
